# EUROPEAN PATENT SPECIFICATION

(11) **EP 2 919 567 B1**
(45) Date of publication and mention of the grant of the patent: **14.02.2018**
(21) Application number: 14189870.0
(22) Date of filing: 22.10.2014
(51) Int. Cl.: H05K 5/06, G01D 11/24, H03K 17/95

(54) **Electronic device**
Elektronische Vorrichtung
Dispositif électronique

(30) Priority: 14.03.2014 JP 2014052567
(43) Date of publication of application: 16.09.2015
(73) Proprietor: OMRON CORPORATION, Kyoto, Kyoto 600-8530 (JP)
(72) Inventor: Nishikawa, Kazuyoshi, Kyoto, Kyoto 600-8530 (JP)
(74) Representative: Horn Kleimann Waitzhofer Patentanwälte PartG mbB

(56) References cited:
- DE-A1- 4 023 792

## Description

### FIELD

The present invention relates to an electronic device, and in particular to an electronic device that is filled with a thermoplastic resin or a thermosetting resin so as to have a sealing property.

### BACKGROUND

JP H09-092105A discloses a design in which the sealing property (mainly, the water resistance) of a closing member depends on the adhesive property between a filling resin and the closing member.

JP H09-092105A is an example of background art.

DE 40 23 792 A1 discloses an electronic device comprising a casing, a detection coil unit and a cable. The detection coil unit and the cable are molded by injection molding with an injection molding tool. The molded unit is then inserted into the casing.

### SUMMARY

In the use environment of a device disclosed in the above-noted JP H09-092105A, when the filling resin is detached from the closing member due to repeated thermal expansion and contraction of the filling resin caused by the temperature difference in the ambient environment, the required sealing property cannot be maintained. If that phenomenon causes an operational defect of the electronic device before the product service life elapses, this will significantly damage the factory activity, that is, peripheral equipment will emergently be stopped, for example.

Typically, in order to suppress the filling resin from being detached, a method is conceivable for mitigating expansion and contraction stresses of the filling resin using the material characteristics (e.g., bending elastic modulus and the like) of the closing member (mitigation by letting the closing member deform according to the expansion and contraction deformation of the filling resin). However, in this method, there are fewer material options for the closing member, resulting in a low flexibility in material selection, and the risk in stable procurement may increase due to a cost increase or production stoppage of the material. Furthermore, other characteristics (e.g., metal moldability) of the material of the closing member may be damaged, possibly increasing the risk that the production yield of the closing member is reduced.

It is an object of the present invention to provide an electronic device that can prevent water from entering from a fitting section between a main case and a closing member even under the use environment of the electronic device in which thermal expansion and contraction may occur repeatedly.

Disclosed is an electronic device with the features of claim 1. An electronic device according to the present invention includes: a main case that is tubular; a closing member that closes an opening on one side of the main case; an electronic component that is arranged inside surrounded by the main case and the closing member; and a resin section that is formed by a resin injected into the main case. The closing member has an extension section that forms a space between the extension section and the main case over the entire circumference of the extension section that is opposite to the inner surface of the main case, the space being filled with the resin. The resin section includes a first section that is provided in the space, and a second section other than the first section. The extension section has, over the entire circumference thereof, an engagement structure for preventing the resin section of the first section from being shifted in the axial direction of the main case.

By adopting such an extension section, it is possible to prevent the filling resin from being detached from the closing member even when the electronic device is used under the temperature environment in which thermal expansion and contraction occur repeatedly, realizing the excellent water resistance (sealing property). Furthermore, by eliminating the adhesive property restriction (restriction that requires a predetermined adhesion strength or greater) between the filling resin and the closing member, it is possible to increase the degree of freedom in selection of the material for the closing member, that is, to eliminate, for example, a restriction depending on the property such as the bending elastic modulus. By increasing such a degree of freedom in selection of the material, it is possible to reduce the material cost for the closing member, to realize the stable procurement thereof, and to adopt the material excellent in molding property, improving the production yield of the closing member.

It is preferable that the resin section of the first section includes a base end section having a first thickness in the direction toward the main case from the central axis of the main case, and a top end section having a second thickness that is larger than the first thickness in the direction toward the main case from the central axis of the main case.

It is furthermore preferable that the thickness of the base end section in the direction toward the main case from the central axis of the main case is 0.2 to 1.0 mm.

By adopting this configuration, it is possible to substantially eliminate expansion and contraction stresses occurring in the extending direction of the resin section due to a temperature change.

It is furthermore preferable that the thickness of the top end section in the direction toward the main case from the central axis of the main case is larger than the thickness of the base end section by 0.1 mm or more. This difference of 0.1 mm in thickness exerts the effect of the engagement structure.

It is furthermore preferable that the thickness of the top end section in the direction toward the main case from the central axis of the main case is 1.5 mm or less.

By adopting this configuration, it is possible to prevent the effect of the expansion and contraction stress of the top end section from becoming relatively large.

It is preferable that the base end section and the top end section of the first section are formed adjacent to each other in the axial direction.

It is furthermore preferable that the total length in the axial direction of the base end section and the top end section is 1.0 mm to 10.0 mm.

By adopting this configuration, it is possible to configure the electronic device that exerts the effect of the engagement structure without damaging the fillability with resin.

It is preferable that the resin section of the first section further includes an intermediate section between the base end section and the top end section, and the intermediate section is configured such that its thickness from the central axis of the main case toward the main case varies along the axial direction, generating, when a force for letting an end of the first section be closer to the second section is generated due to contraction of the resin section, a reactive force to the extension section in the axial direction.

By adopting this configuration, it is possible to make the angle given by a border between the base end section and the top end section larger than 90°, making it possible to improve the moldability during manufacture of the extension section, and to further improve the production yield of the closing member.

It is furthermore preferable that the angle given by the border between the base end section and the top end section is in the range from 90° to 150°. By adopting this configuration, it is possible to exert the effect of the engagement structure while increasing the productivity of the closing member.

It is furthermore preferable that, when viewed in a cross section including the central axis of the main case, a border between the intermediate section and the extension section is formed on a line that connects an end of a border between the base end section and the extension section, to an end of a border between the top end section and the extension section, the ends being close to each other, and has a projection whose top has an acute angle.

By adopting such a configuration, it is possible to design relatively freely the shape of the intermediate section between the base end section and the top end section, and a bent section adjacent thereto, making it possible to improve the moldability in manufacturing of the extension section, and to further improve the production yield of the closing member. Furthermore, by adopting appropriate shapes for the intermediate section and the bent section adjacent thereto, it is possible to further improve the effect of the engagement structure.

Alternatively, it is further preferable that, when viewed in a cross section including the central axis of the main case, the border between the intermediate section and the extension section is configured by a combination of a plurality of lines, and a pair of lines selected from:
- two adjacent lines of said plurality of lines,
- a border (border line) between the base end section and the extension section, and one of said plurality of lines adjacent thereto, and
- a border between the top end section and the extension section, and one of said plurality of lines adjacent thereto,
defines an angle that is larger than a right angle.

By adopting such a configuration, it is possible to design relatively freely the shape of the intermediate section between the base end section and the top end section, making it possible to improve the moldability in manufacturing of the extension section, and to further improve the production yield of the closing member. Furthermore, by adopting an appropriate shape for the intermediate section, it is possible to further improve the effect of the engagement structure.

Alternatively, it is furthermore preferable that, when viewed in a cross section including the central axis of the main case, the border between the intermediate section and the extension section includes an arc.

By adopting such a configuration, it is possible to design relatively freely the shape of the intermediate section between the base end section and the top end section, making it possible to improve the moldability in manufacturing of the extension section, and to further improve the production yield of the closing member. Furthermore, by adopting an appropriate shape for the intermediate section, it is possible to further improve the effect of the engagement structure.

It is preferable that the resin is selected from a thermoplastic resin and a thermosetting resin.

The shape of the main case is not limited to a cylinder, and the main case may have another cylindrical shape such as a rectangular tube, a multiangular tube, or an elliptic tube.

According to the electronic device of the present invention, it is possible to prevent water from entering from the fitting section between the main case and the closing member even under the use environment of the electronic device in which thermal expansion and contraction may occur repeatedly.

### BRIEF DESCRIPTION OF THE DRAWINGS

FIG. 1 is a perspective view illustrating a proximity sensor according to Embodiment 1.
FIG. 2 is a perspective view illustrating a state in which the proximity sensor of Embodiment 1 is exploded.
FIG. 3 is a cross-sectional view taken along the line III-III of FIG. 1.
FIG. 4 is a cross-sectional view taken along the line IV-IV of FIG. 1.
FIG. 5 is an enlarged cross-sectional view illustrating the vicinity of a detecting unit included in the proximity sensor of Embodiment 1.
FIG. 6 is a cross-sectional view schematically illustrating an extension section that is used for the proximity sensor of Embodiment 1.
FIG. 7 is a cross-sectional view schematically illustrating an extension section that is used for a proximity sensor according to Embodiment 2.
FIG. 8 shows cross-sectional views schematically illustrating extension sections that are used for a proximity sensor according to Embodiment 3.
FIG. 9 shows schematic cross-sectional views illustrating other extension sections that are used for the proximity sensor according to Embodiment 3.
FIG. 10 shows schematic cross-sectional views illustrating yet other extension sections that are used for the proximity sensor according to Embodiment 3.
FIG. 11 is a perspective view illustrating a proximity sensor according to Embodiment 4.

### DETAILED DESCRIPTION

Hereinafter, embodiments and examples according to the present invention will be described with reference to the drawings. In the description of the embodiments and examples, when the number of pieces, amount, and the like are mentioned, the scope of the present invention is not necessarily limited to that number of pieces, amount, and the like, unless otherwise noted. In the description of embodiments and examples, the same reference numerals are given to the same members and corresponding members, and descriptions thereof may not be repeated.

In the following description, a proximity sensor will be described as an example of an electronic device according to the present invention, but the present invention is not limited thereto and can be implemented as various types of electronic devices. Note however that the present invention is preferably implemented as any of various types of sensors, taking the sealing property of the electronic device according to the present invention into consideration.

### [Embodiment 1]

### [Overall Configuration]

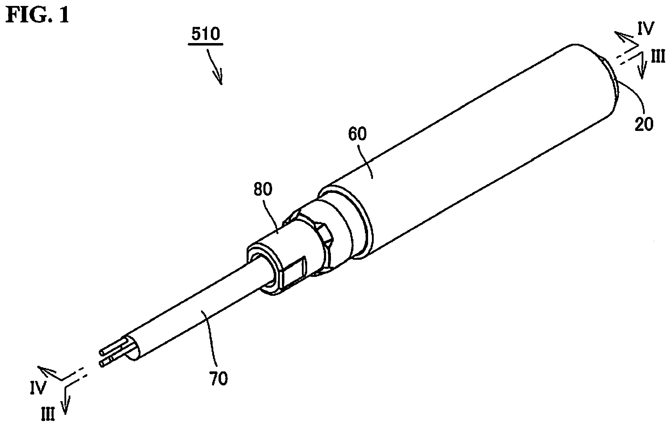

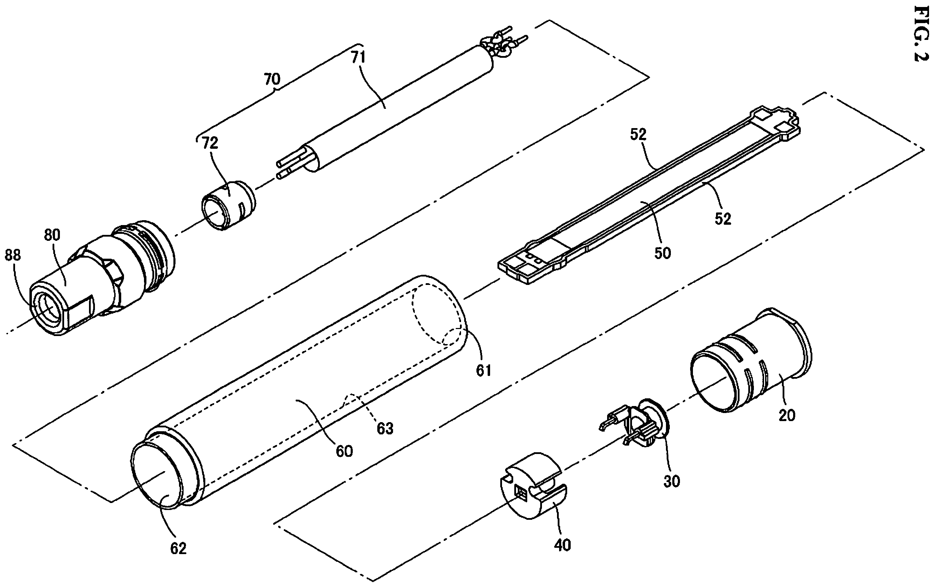

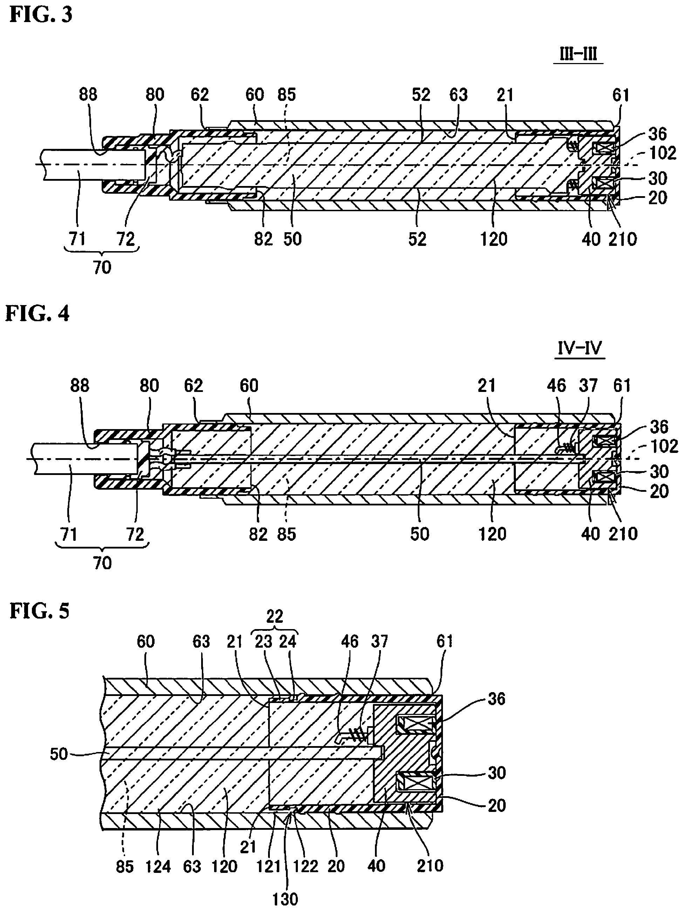

A proximity sensor 510 according to the present embodiment will be described with reference to FIGS. 1 to 5. FIG. 1 is a perspective view illustrating the proximity sensor 510 of Embodiment 1. FIG. 2 is a perspective view illustrating an exploded state of the proximity sensor 510 of Embodiment 1. FIG. 3 is a cross-sectional view taken along the line III-III of FIG. 1. FIG. 4 is a cross-sectional view taken along the line IV-IV of FIG. 1. FIG. 5 is an enlarged cross-sectional view illustrating the vicinity of a detecting unit 210 included in the proximity sensor 510 of Embodiment 1.

Referring to FIGS. 1 to 5, the proximity sensor 510 is an inductive proximity sensor that generates a magnetic field in a detection region to detect whether or not a detection target is approaching or present. The detection target that is detected by the proximity sensor 510 is a conductive object. The detection target that is detected by the proximity sensor 510 typically includes magnetic metal such as iron. The detection target that is detected by the proximity sensor 510 may also include nonmagnetic metal such as copper or aluminum.

The proximity sensor 510 has an outer appearance extending cylindrically along a phantom central axis 102 (see FIGS. 3 and 4). The proximity sensor 510 includes the detecting unit 210 (see FIGS. 3 to 5), a coil case 20, a printed board 50 (see FIGS. 2 to 5), a base metal fitting 60, which serves as a housing, a clamp 80, and a ring cord 70.

The detecting unit 210 detects whether or not a detection target is approaching or present. As an example, the detecting unit 210 generates a magnetic field by flowing a current through a coil, and detects whether or not a detection target is approaching or present using an electromagnetic interaction between the generated magnetic field and the detection target. The detecting unit 210 is provided on the front end side of the proximity sensor 510 that faces the detection region. The detecting unit 210 mainly includes a core 40, an electromagnetic coil 36 (see FIGS. 3 to 5), and a coil spool 30 (see FIGS. 2 to 5).

The core 40 is made from a material having an excellent high frequency property, such as ferrite, for example. The core 40 has the function to increase the coil characteristics (e.g. inductivity) of the detecting unit 210, and to concentrate magnetic fluxes in the detection region. The electromagnetic coil 36 is formed by a coil wire being wound on the coil spool 30. The electromagnetic coil 36 is wound around the central axis 102. According to the present embodiment, the central axis around which the electromagnetic coil 36 is wound is configured to be identical with the central axis 102.

The coil spool 30 is made from an electric insulating resin. The coil spool 30 is accommodated in a circular groove formed in the core 40. A coil pin 46 is made from conductive metal. The coil pin 46 is supported by the coil spool 30. The coil pin 46 has the shape of protruding from the detecting unit 210 to the printed board 50. The protruding end of the coil pin 46 is connected to a conductive region formed on the printed board 50.

An end 37 of the electromagnetic coil 36 that is drawn from the outer circumference of the coil spool 30 is wound around the root section of the coil pin 46 that protrudes from the detecting unit 210. The electromagnetic coil 36 and the printed board 50 are electrically connected to each other via the coil pin 46 and solder (not shown).

The detecting unit 210 is accommodated in the coil case 20. The coil case 20 functions as a front cover that is mounted in an opening on the front end side of the base metal fitting 60. The coil case 20 is typically made from a material such as a thermoplastic resin that has an excellent adhesive property to a resin with which a resin section 120 is formed. A material of the coil case 20 may appropriately be selected from, for example, ABS, PC (polycarbonate), POM (polyacetal), PBT (polybutylene terephthalate), PA (polyamide), PE (polyethylene), PP (polypropylene), PES (polyether sulfone), PPS (Polyphenylenesulfide), LCP (liquid crystal polymer), and PS (polystyrene), and mixtures thereof.

The coil case 20 is provided so as to serve as a cover for the front end side on which the detecting unit 210 is accommodated. The coil case 20 can function as a closing member for closing the base metal fitting 60, and fills up the opening on the front end side (that is, on opening 61 on one side) of the base metal fitting 60, which serves as a main case, which may also be referred to as "casing". The coil case 20 is provided mainly for blocking and protecting the detecting unit 210 from the outer atmosphere.

The coil case 20 has the shape of a cylinder with a bottom. The coil case 20 cylindrically extends along the central axis 102, and has such a shape that one end thereof is closed and the other end thereof is open. The end face of the coil case 20 on the closed end side constitutes a detection surface of the proximity sensor 510. The detecting unit 210 is arranged inside the tubular section of the coil case 20.

The printed board 50 has an elongated flat plate shape. The printed board 50 extends such that the longitudinal direction thereof is the axial direction of the central axis 102. The printed board 50 has side faces 52 that extend in the longitudinal direction (see FIGS. 2 and 3). Various types of electronic components (not shown), such as a transistor, a diode, a resistor, and a capacitor, are mounted on the printed board 50. These electronic components are sealed by a resin, and encompass components that are electrically connected to the detecting unit 210.

The base metal fitting 60 functions as a tubular main case for accommodating the electronic components such as a transistor, a diode, a resistor, and a capacitor. The base metal fitting 60 is closed by the coil case 20 on one end (namely, the opening 61 on one end). The base metal fitting 60 forms a contour of the proximity sensor 510 at a certain distance from the central axis 102. The base metal fitting 60 has the shape of cylindrically extending along the central axis 102. The shape of the base metal fitting 60 is not limited to that cylindrical shape, and may also be other cylindrical shapes such as a rectangular cylinder, a polyangular cylinder, or an elliptic cylinder. The main case may be made from a resin member.

In the state in which the base metal fitting 60, the coil case 20, the ring cord 70, and the clamp 80 are incorporated, an accommodation section 85, which serves as an accommodation space, is formed inside these components. In the state in which the proximity sensor 510 has been manufactured, the printed board 50 and the electronic components, together with the resin section 120, are located in the accommodation section 85. That is, the printed board 50 and the electronic components are arranged in the internal space enclosed by the base metal fitting 60, which serves as the main case, and the coil case 20, which serve as the closing members.

The base metal fitting 60 extends around the central axis 102 and is opened on its two ends. The base metal fitting 60 has the opening 61 on one end side in the longitudinal direction, and an opening 62 on the other end side in the longitudinal direction. The openings 61 and 62 communicate with each other via the internal space formed inside an inner surface 63 of the base metal fitting 60. The inner surface 63 of the present embodiment is circular, when seen in the cross-sectional view in the direction that is orthogonal to the central axis 102, at any position in the direction in which the central axis 102 extends.

The base metal fitting 60 is made from metal. The base metal fitting 60 includes, on its outer circumferential surface, a screw for use for fixing the proximity sensor 510 to external equipment. The above-described coil case 20 is inserted into the opening 61 of the base metal fitting 60 on one end side, and is fixed to the base metal fitting 60. As described above, the coil case 20 can serve as a closing member, and closes the opening 61 of the base metal fitting 60..

The clamp 80 is provided as a connection member that is connected to the base metal fitting 60 from the rear end side of the proximity sensor 510. The clamp 80 is connected to the rear end of the cylindrical base metal fitting 60. The clamp 80 is inserted into the opening on the rear end side of the base metal fitting 60 (that is, the other opening 62). The clamp 80, together with the base metal fitting 60, extends cylindrically along the central axis 102.

The ring cord 70 is electrically connected to the printed board 50 inside the accommodation section 85. The ring cord 70 is inserted into the clamp 80 and drawn from an opening 88 on the rear end side of the clamp 80 (rear end of the accommodation section 85). The ring cord 70 closes the opening 88 on the rear end side of the clamp 80 (rear end of the accommodation section 85). The ring cord 70 and the clamp 80, integrated into one piece, close the opening (the other opening 62) on the rear end side of the cylindrical base metal fitting 60.

The ring cord 70 includes a cable 71 and a ring member 72. The ring member 72 is provided so as to cover an end of the cable 71 in the cylindrical case 310. The ring member 72 ensures connectivity between the resin section 120, which is provided in the accommodation section 85 and will be described later, and the cable 71. The ring member 72 is made from, for example, PBT (polybutylene terephthalate). The cable 71 is covered with, for example, polyvinyl chloride.

The resin section 120 is formed by a resin being injected into an internal space (in the accommodation section 85) of the base metal fitting 60, which serves as the main case. The resin section 120 is located in the accommodation section 85, which is surrounded by the base metal fitting 60, the coil case 20, which closes one opening 61 of the base metal fitting 60, and the ring cord 70 and the clamp 80, which close the other opening 62 of the base metal fitting 60, and is formed as an accommodation space inside these components. The resin section 120 seals the detecting unit 210 accommodated in the coil case 20, the printed board 50 accommodated in the cylindrical case 310, and electronic components mounted on the printed board 50.

### [Resin Section 120]

The resin of the resin section 120 is selected from, for example, a thermoplastic resin, a thermosetting resin, a light curable resin, an ultraviolet curable resin, and a moisture curable resin. Typically, the resin of the resin section 120 is selected from a thermoplastic resin and a thermosetting resin, and seals the detecting unit 210 (the core 40, the electromagnetic coil 36, and the coil spool 30).

A thermoplastic resin that is used for formation of the resin section 120 is at least one type selected from the group consisting of polyolefins, polyesters, and polyamides, for example. The thermoplastic resin that is used for formation of the resin section 120 may include various types of additive agents such as a flame retarder, an organic/inorganic filler, a plasticizer, a coloring agent, and an antioxidant. By using a thermoplastic resin having a hardness (shore D) of 60 or less, it is possible to reduce a stress on the internal devices such as electronic components or the printed board 50. Note that a thermoplastic resin that is used for formation of the resin section 120 is preferably a so-called hot melt resin.

On the other hand, when a thermosetting resin is used, an epoxy resin is typically used. The resin section 120 preferably has a low variation in resin stress (relaxation of stress) that is affected on the detecting unit 210. The thermosetting resin that is used for the resin section 120 is preferably a resin whose elastic modulus at ambient temperature is 800 MPa or more. The thermosetting resin that is used for the resin section 120 may include various types of additive agents such as a flame retarder, an organic/inorganic filler, a plasticizer, a coloring agent, and an antioxidant.

Furthermore, as a resin of the resin section 120, a resin having a relatively high linear expansion coefficient of, for example, 90×10⁻⁶/°C or more may be used. Even when such a resin having a high linear expansion coefficient is used for the resin section 120, adopting the configuration according to the embodiment as will be described below can ensure the sealing property even under the use environment of the electronic device in which a temperature difference is large.

In the state in which the proximity sensor 510 has been manufactured, the resin section 120 has a shape extending from the coil case 20 (one opening 61) to the ring cord 70 and clamp 80 (the other opening 62). The technical meaning of "shape extending ..." includes shapes of the resin section 120 that extend from the ring cord 70 and clamp 80 to the coil case 20.

As shown in FIG. 5, an extension section 22 is formed between the coil case 20 and the resin section 120. The extension section 22 has a configuration for improving the sealing property between the coil case 20 and the resin section 120, in particular, for ensuring the sealing property under the use environment of the electronic device in which a temperature difference is large.

As shown in FIG. 5, an extension section having a step structure with an anchoring section 24 is provided on the outer periphery of an open end of the coil case 20 including a rib-shaped section 23. A gap 130 is formed between the base metal fitting 60 and the open end 21 on the rear end side of the coil case 20. The gap 130 forms a tubular space that has a shape corresponding to that of the base metal fitting 60, namely, the shape of a cylinder in the present embodiment.

The gap 130 is formed over the entire circumference of the extension section 22 between the extension section 22 extending from the coil case 20 and the inner surface 63 of the base metal fitting 60 so as to surround the extension section 22 from the outside in the radial direction. That is, the coil case 20, serving as a closing member, includes the extension section 22 that forms a space that is filled with a resin between the extension section 22 and the base metal fitting 60 over the entire circumference that is opposite to the inner surface 63 of the base metal fitting 60, serving as the main case.

### <Extension section 22>

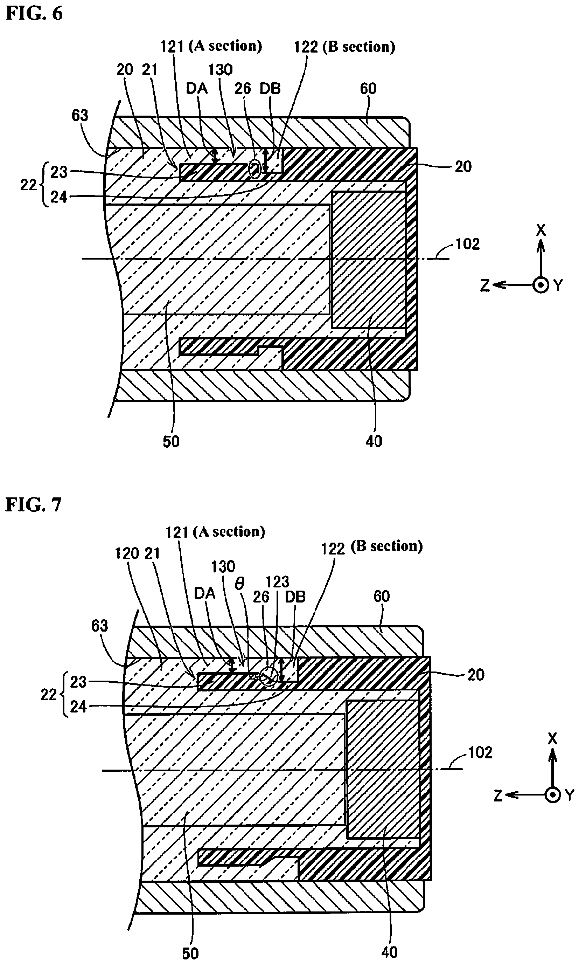

The extension section 22 of the present embodiment will be described with reference to FIG. 6. FIG. 6 is a cross-sectional view schematically illustrating the extension section 22 that is used for the proximity sensor of Embodiment 1. In the schematic diagram of FIG. 6, for ease of description, the direction in which the central axis 102 extends is defined as the Z axis, and the two-dimensional surface when viewed in a cross section in the direction that is orthogonal to the axial direction of the central axis 102 is defined by the X and Y axes.

When the extension section 22 uses a thinned sealing structure in which the thickness of the resin section is relatively small, expansion and contraction stresses in the direction (Z direction) in which the resin section extends are removed. That is, the resin section that is present in a space between the rib-shaped section 23 of the coil case 20 and the inner surface 63 of the base metal fitting 60 is referred to also as "base end section 121" or "A section", for ease of description. By setting a thickness DA of the base end section 121 to 0.2 mm to 1.0 mm for example, it is possible to set the expansion and contraction stresses of the resin section occurring in the Z direction due to a temperature change to substantially zero. The expansion and contraction stresses occurring in the Z direction induces the resin section 120 to be detached from the outer surface of the coil case 20, but this phenomenon is suppressed by appropriately designing the thickness of the resin section.

In addition, the extension section 22 has an anchoring section 24 that forms a step with respect to the rib-shaped section 23. The resin section that is present between the anchoring section 24 of the coil case 20 and the inner surface 63 of the base metal fitting 60 is referred to also as "top end section 122" or "B section", for ease of description. By adopting the anchoring section 24, expansion and contraction stresses of the resin section occurring in the surface direction (X-Y direction) due to a temperature change can be retained by an anchoring effect (engagement effect) using the anchoring structure. Then, these expansion and contraction stresses are converted into press stresses. That is, a bent section 26 of the anchoring that is present between the rib-shaped section 23 of the extension section 22 and the anchoring section 24 receives, on its surface, expansion and contraction stresses of the resin section as press stresses. Accordingly, by converting expansion and contraction stresses of the resin section into press stresses, it is possible to suppress the resin section from being detached from the coil case 20 and the inner surface 63 of the base metal fitting 60.

By adopting the extension section 22 serving as the extension section of the coil case 20, the gap 130 is formed between the base metal fitting 60 and the open end 21 on the rear end side of the coil case 20. A resin with which the gap 130 is filled includes the base end section 121 and the top end section 122, which are provided in the space (gap 130) formed by the extension section 22 that is an extension section. By varying the thickness of the resin with which the gap 130 is filled, the extension section 22 functions as an engagement structure for preventing, on the entire circumference thereof, the resin section of the base end section 121 from being shifted in the direction of the central axis 102 of the main case.

Here, the technical meaning of "engagement structure" includes the function to remove expansion and contraction stresses occurring to the injected resin in the Z direction (central axis direction) due to a temperature change, and/or, the function of guiding the expansion and contraction stress that have occurred, in another direction. The "engagement structure" may have, in addition to the below described configuration, any configuration that is obtained by the extension section 22 being cut 360-degree several times intermittently so as to be corrugated, textured, polka-dotted, or the like, as long as it exerts an effect for preventing the resin section from being shifted.

The inventors of the present application found a new fact that, by making the thickness of the resin section in the direction from the central axis 102 of the base metal fitting 60 (main case) to the base metal fitting 60 (thickness in the radial direction) relatively thin, it is possible to substantially remove expansion and contraction stresses of the resin section occurring in the Z direction due to a temperature change. The reason is that it is presumed that the thickness of the resin section by which the resin section is caught without an influence of a temperature is 0.2 mm to 1.0 mm, and from this presumption, it is considered that, when the thickness of the resin section is maintained as 0.2 mm to 1.0 mm, the thickness can be maintained irrespective of the surface state, making it possible to suppress expansion and contraction stresses from occurring. Note that, when the resin section is made too thin, the required sealing property may not be maintained, and it is thus preferable to maintain the thickness as 0.2 mm. That is, a thickness DA of the base end section 121 in the direction that is orthogonal to the central axis direction is 0.2 to 1.0 mm.

On the other hand, in order to exert the anchoring effect, a difference in thickness between the base end section 121 and the top end section 122 is necessary. That is, a thickness DB of the top end section 122 (B section) in the direction from the central axis 102 of the base metal fitting 60 (main case) toward the base metal fitting 60 is configured to be larger than the thickness DA of the base end section 121 (A section). That is, the resin section provided in the gap 130 having the engagement structure of the present embodiment includes the base end section 121 that has the thickness DA (first thickness) in the direction from the central axis 102 of the base metal fitting 60 (main case) toward the base metal fitting 60 (main case), and the top end section 122 that has the thickness DB (second thickness) in the direction from the central axis 102 of the base metal fitting 60 (main case) toward the base metal fitting 60 (main case) that is larger than the thickness DA. As described later, the inventors of the present application found that a difference in thickness for exerting this anchoring effect needs to be 0.1 mm. That is, the thickness DB of the top end section 122 in the direction from the central axis 102 of the base metal fitting 60 (main case) toward the base metal fitting 60 is preferably larger than the thickness DA of the base end section 121 by 0.1 mm or more. However, when the thickness DB of the top end section 122 is too large, the effect of the expansion and contraction stress is relatively large, and thus it is preferable to set an upper limit. According to the present embodiment, as an example, the upper limit of the thickness DB of the top end section 122 in the direction from the central axis 102 of the base metal fitting 60 (main case) toward the base metal fitting 60 is preferably set to 1.5 mm.

A structure in which the base end section 121 (A section) and the top end section 122 (B section) are formed adjacent to each other in the axial direction of the central axis 102 is taken as an example of the engagement structure of the present embodiment, but the present invention is not limited to this structure as long as the structure exerts the anchoring effect, as will be described below.

### <Embodiment 1>

The following shows the results of evaluation about water resistance and shock resistance of a proximity sensor of the present embodiment, the results being obtained while varying the thicknesses of the base end section 121 and the top end section 122. Embodiment 1 shows an example in which a hot melt resin, which is a thermoplastic resin, is used for a resin seal. An IP67 test defined by International Electrotechnical Commission (IEC) and Japanese Industrial Standards (JIS) is used as a method for evaluating water resistance, and excellence of water resistance is determined based on whether or not the insulating resistance value exceeds 50 MΩ. Furthermore, a method for evaluating thermal shock resistance is performed where an operation (repeated thermal shock) in which a product to be evaluated is exposed to the environments of -25°C and 70°C each for 30 minutes is regarded as one cycle, the product is subjected to that cycle one hundred times repeatedly, and then excellence of thermal shock resistance is determined based on whether or not the insulating resistance value exceeds 50 MΩ. In the table, "Pass" shows that the insulating resistance value exceeds 50 MΩ, whereas "Fail" shows that the insulating resistance value is 50 MΩ or less.

From the results shown below, it is found that the following conditions are appropriate for the thicknesses of the base end section 121 and the top end section 122:
(1) The thickness of the base end section 121 is in the range from 0.2 mm to 1.0 mm; and
(2) The thickness of the top end section 122 is "thickness of the base end section 121 + 0.1 mm" or more, and the absolute value of that thickness is 1.5 mm or less.

Examples 1 to 4 shown in the table below are examples in which the thickness of the base end section 121 is varied in the range from 0.2 mm to 1.0 mm, and the thickness of the top end section 122 is also varied with variation in thickness of the base end section 121, so as to satisfy the above-described condition (2). Note that the top end section 122 is assumed to be convex-shaped with respect to the base end section 121.

As shown in the table below, in the cases where the thicknesses of the base end section 121 are 0.1 mm (Comparative Example 1) and 1.1 mm (Comparative Example 2), the required water resistance and shock resistance cannot be exerted. More specifically, in Comparative Example 1, in which the thickness of the base end section 121 is 0.1 mm, a flow path through which a resin is injected could not be ensured sufficiently, resulting in insufficient filling, and the required sealing property could not be achieved. Furthermore, in Comparative Example 2 in which the thickness of the base end section 121 is 1.1 mm, the base end section 121 is detached from the inner surface 63 of the base metal fitting 60 due to expansion and contraction stresses, and the required sealing property could not be achieved.

In contrast thereto, it is clear that all Examples 1 to 4, in which the thickness of the base end section 121 is in the range from 0.2 mm to 1.0 mm, satisfy both the requirements of the water resistance and shock resistance. Note that the case where the thickness of the base end section 121 is 0.2 mm (Example 1) shows the lower limit of the thickness needed for ensuring the required flow path for resin injection, whereas the case where the thickness of the base end section 121 is 1.0 mm (Example 4) shows the upper limit of the thickness for preventing the base end section 121 from being detached in the thickness direction.

**[Table 1]**

| | Comp. Ex. 1 | Ex. 1 | Ex. 2 | Ex. 3 | Ex. 4 | Comp. Ex. 2 |
|---|---|---|---|---|---|---|
| Resin section | Thermoplastic resin | | | | | |
| Thickness of A section (mm) | 0.1 | 0.2 | 0.3 | 0.9 | 1.0 | 1.1 |
| Thickness of B section (mm) | 0.2 | 0.3 | 0.4 | 1.0 | 1.1 | 1.2 |
| Water resistance evaluation | Fail | Pass | Pass | Pass | Pass | Fail |
| Thermal | Fail | Pass | Pass | Pass | Pass | Fail |
| shock resistance evaluation | | | | | | |
| Reason | Insufficient sealing property due to insufficient filling with resin | Lower limit of thickness of A section in view of fillability with resin | | | Upper limit of thickness of A section in view of detachability in thickness direction | Insufficient sealing property due to detachment of A section |

Next, Examples 1, and 5 to 7 shown in the table below are examples in which the thickness of the base end section 121 is 0.2 mm, and the thickness of the top end section 122 is varied in the range from 0.2 to 1.6 mm. Furthermore, Examples 4, and 8 to 10 shown in the table below are examples in which the thickness of the base end section 121 is 1.0 mm, and the thickness of the top end section 122 is varied in the range from 1.0 to 1.6 mm.

As shown in the table below, in the case where the thickness of the base end section 121 is 0.2 mm and the thickness of the top end section 122 is 0.2 mm (Comparative Example 3), there is no difference in thickness between the base end section 121 and the top end section 122, and no anchoring effect is exerted. Therefore, even if water resistance is ensured before a thermal shock is applied, the thermal shock resistance may be deteriorated by a repeated thermal shock. Furthermore, in the case where the thickness of the base end section 121 is 1.0 mm and the thickness of the top end section 122 is 1.0 mm (Comparative Example 5), the thermal shock resistance may be deteriorated by a repeated thermal shock for the same reason as that of Comparative Example 3.

Furthermore, in the case where the thickness of the base end section 121 is 0.2 mm and the thickness of the top end section 122 is 1.6 mm (Comparative Example 4), expansion and contraction stresses of the top end section 122 may damage the anchoring effect. That is, even if water resistance is ensured before a thermal shock is applied, the thermal shock resistance may be deteriorated by a repeated thermal shock. Furthermore, in the case where the thickness of the base end section 121 is 1.0 mm and the thickness of the top end section 122 is 1.6 mm (Comparative Example 6) as well, the thermal shock resistance may be deteriorated by a repeated thermal shock for the same reason as that of Comparative Example 4.

In contrast thereto, it is clear that, by setting the upper limit of the thickness of the top end section 122 to 1.5 mm so that the upper limit is larger than the thickness of the base end section 121 by 0.1 mm or more (Examples 1, and 4 to 10), the requirements of the water resistance and shock resistance are satisfied.

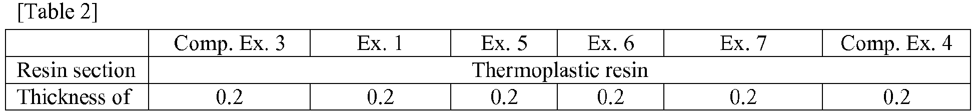

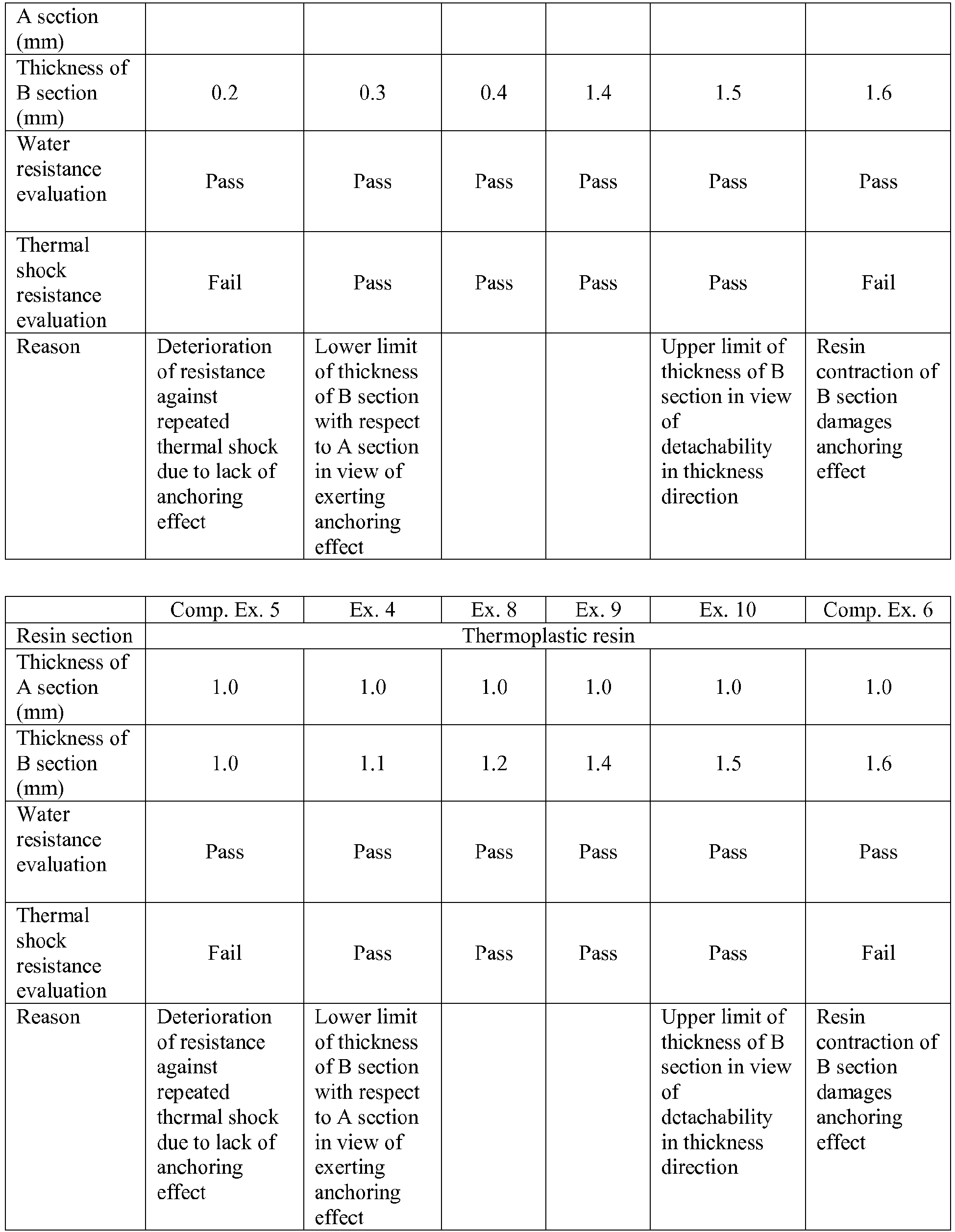

### <Example 2>

The following will describe Example 2 as an example in which an epoxy resin, which is a thermosetting resin, is used for a resin seal. Example 2 differs from the foregoing Example 1 only in the material that constitutes the resin section 120, and uses the same examples of design of the thicknesses of the base end section 121 and the top end section 122, and the same method for evaluating the water resistance and shock resistance as those of Example 1.

Examples 1A to 4A shown in the table below are examples in which the thickness of the base end section 121 is varied in the range from 0.2 mm to 1.0 mm, and the thickness of the top end section 122 is also varied with variation in thickness of the base end section 121, so as to satisfy the above-described condition.

As shown in the table below, in the cases where the thicknesses of the base end section 121 are 0.1 mm (Comparative Example 1A) and 1.1 mm (Comparative Example 2A), the required water resistance and shock resistance cannot be exerted. More specifically, in Comparative Example 1A, in which the thickness of the base end section 121 is 0.1 mm, and Comparative Example 2A, in which the thickness of the base end section 121 is 1.1 mm, similarly to Comparative Examples 1 and 2 of the foregoing Example 1, the base end section 121 is detached from the inner surface 63 of the base metal fitting 60, and the required sealing property could not be achieved.

In contrast thereto, it is clear that all Examples 1A to 4A, in which the thickness of the base end section 121 is in the range from 0.2 mm to 1.0 mm, satisfy both the requirements of the water resistance and shock resistance.

**[Table 3]**

| | Comp. Ex. 1A | Ex. 1A | Ex. 2A | Ex. 3A | Ex. 4A | Comp. Ex. 2A |
|---|---|---|---|---|---|---|
| Resin section | Thermosetting resin | | | | | |
| Thickness of A section (mm) | 0.1 | 0.2 | 0.3 | 0.9 | 1.0 | 1.1 |
| Thickness of B section (mm) | 0.2 | 0.3 | 0.4 | 1.0 | 1.1 | 1.2 |
| Water resistance evaluation | Fail | Pass | Pass | Pass | Pass | Fail |
| Thermal shock resistance evaluation | Fail | Pass | Pass | Pass | Pass | Fail |
| Reason | Insufficient sealing property due to insufficient filling with resin | Lower limit of thickness of A section in view of fillability with resin | | | Upper limit of thickness of A section in view of detachability in thickness direction | Insufficient sealing property due to detachment of A section |

Next, Examples 1A, and 5A to 7A shown in the table below are examples in which the thickness of the base end section 121 is 0.2 mm, and the thickness of the top end section 122 is varied in the range from 0.2 to 1.6 mm. Furthermore, Examples 4, and 8 to 10 shown in the table below are examples in which the thickness of the base end section 121 is 1.0 mm, and the thickness of the top end section 122 is varied in the range from 1.0 to 1.6 mm.

As shown in the table below, in the case where the thickness of the base end section 121 is 0.2 mm and the thickness of the top end section 122 is 0.2 mm (Comparative Example 3A), and in the case where the thickness of the base end section 121 is 1.0 mm and the thickness of the top end section 122 is 1.0 mm (Comparative Example 5A), no anchoring effect is exerted. Therefore, even if water resistance is ensured before a thermal shock is applied, the thermal shock resistance may be deteriorated by a repeated thermal shock.

Furthermore, in the case where the thickness of the base end section 121 is 0.2 mm and the thickness of the top end section 122 is 1.6 mm (Comparative Example 4A), and the case where the thickness of the base end section 121 is 1.0 mm and the thickness of the top end section 122 is 1.6 mm (Comparative Example 6A) as well, the thermal shock resistance may be deteriorated by a repeated thermal shock for the same reason as that of Comparative Examples 4 and 6 of Example 1.

In contrast thereto, it is clear that, by setting the upper limit of the thickness of the top end section 122 to 1.5 mm so that the upper limit is larger than the thickness of the base end section 121 by 0.1 mm or more (Examples 1A, and 4A to 10A), the requirements of the water resistance and shock resistance are satisfied.

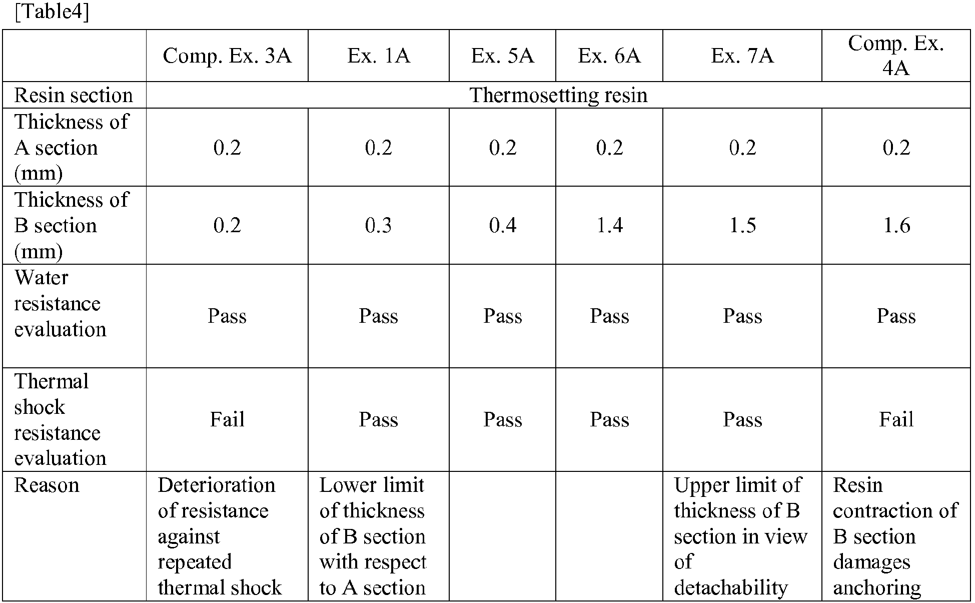

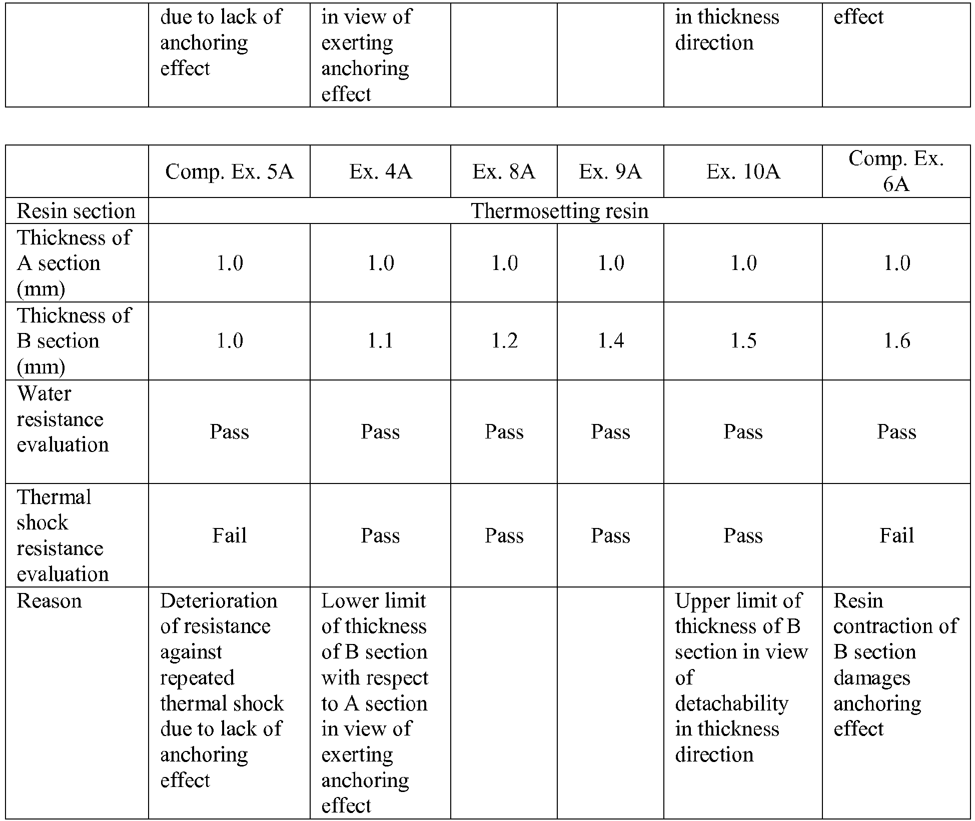

### <Example 3>

The following shows the results of evaluation about water resistance and shock resistance of a proximity sensor of the present embodiment, the results being obtained while varying the lateral lengths (length in the axial direction of the central axis 102) of the base end section 121 and top end section 122.

From the results shown below, it is found that the following conditions are appropriate for the lateral lengths of the base end section 121 and the top end section 122.
(1) The total length in the lateral direction of the base end section 121 and the top end section 122 is in the range from 1.0 mm to 10.0 mm;
(2) With respect to the relationship between the total length in the lateral direction of the base end section 121 and the top end section 122, and the thicknesses thereof:
   (2-1) When the thickness of the top end section 122 exceeds 1.0 mm, the relationship "length of the base end section 121 > length of the top end section 122" is satisfied; and
   (2-2) when the thickness of the top end section 122 is 1.0 mm or less, the lengths of the base end section 121 and the B section are suitably determined in a range in which another condition is satisfied; and
(3) The absolute value of the length in the lateral direction of the top end section 122 is 0.2 mm or more.

The above-described condition (1) is determined in view of the exertion of the anchoring effect and the fillability with resin. More specifically, when the total length in the lateral direction of the base end section 121 and the top end section 122 is less than 1.0 mm, the anchoring effect cannot substantially be exerted. On the other hand, when the total length in the lateral direction of the base end section 121 and the top end section 122 exceeds 10.0 mm, the fillability with resin is deteriorated. Accordingly, the total length of the length of the base end section 121 (A section) in the axial direction of the central axis 102, and the length of the top end section 122 (B section) in the axial direction is preferably designed to be from 1.0 mm to 10.0 mm.

The above-described condition (2) is classified depending on the significance of the influence when the top end section 122 is detached in the thickness direction, and when the influence when the top end section 122 is detached in the thickness direction is relatively large ((2-1) is applied when the thickness of the top end section 122 exceeds 1.0 mm), the relationship "length of the base end section 121 > length of the top end section 122" needs to be satisfied. Whereas, when the influence when the top end section 122 is detached in the thickness direction is relatively small ((2-2) is applied when the thickness of the top end section 122 is 1.0 mm or less), the lengths of the base end section 121 and the B section are suitably determined in a range in which another condition is satisfied.

The above-described condition (3) is a condition for ensuring the fillability with resin. The following will describe the experiment results in which the conditions (1) to (3) are derived. Note that, in the following experiment results, an example in which a hot melt resin, which is a thermoplastic resin, is used as a resin seal is taken, but the same results are also obtained when a thermosetting resin is used.

The following shows, as the experiment results in which the above-described condition (1) was derived, the results that are obtained when the lengths in the lateral direction of the base end section 121 and the top end section 122 are varied respectively, taking the case in which the thickness of the base end section 121 is 0.5 mm and the thickness of the top end section 122 is 0.8 mm, and the angle given by a border of the base end section 121 and the top end section 122 is 90°, as a standard. Note that the angle given by a border between the base end section 121 and the top end section 122 will be described later, but the case where this angle is 90° corresponds to the case where the base end section 121 and the top end section 122 have the step structure as shown in FIG. 6.

As shown in the table below, in the case where the length of the base end section 12 is 0.6 mm and the length of the top end section 122 is 0.2 mm (Comparative Example 7), the required water resistance and shock resistance cannot be exerted. More specifically, since the length in the lateral direction of the resin section 120 (the base end section 121 and the top end section 122) is small, a contraction stress is affected and the anchoring effect cannot be exerted. Accordingly, both the required water resistance and shock resistance cannot be exerted.

Furthermore, in the case where the length of the base end section 121 is 8.2 mm and the length of the top end section 122 is 2.0 mm (Comparative Example 8), the required water resistance and shock resistance cannot be exerted. More specifically, since the total length in the lateral direction of the resin section 120 (the base end section 121 and the top end section 122) exceeds 10.0 mm, the fillability with resin is deteriorated. Therefore, the required water resistance and shock resistance cannot be exerted.

In contrast thereto, it is clear that all Examples 11 to 14, in which the total length in the lateral direction of the base end section 121 and the top end section 122 is in the range from 1.0 mm to 10.0 mm, satisfy the requirements of the water resistance and shock resistance. Of these examples, Example 11 is determined to show the lower limit of the total length in the lateral direction since the individual variation in thermal shock resistance starts occurring, and Example 14 is determined to show the upper limit of the total length in the lateral direction since the individual variation in fillability with resin of the top end section 122 starts occurring.

**[Table 5]**

| | Comp. Ex. 7 | Ex. 11 | Ex. 12 | Ex. 13 | Ex. 14 | Comp. Ex. 8 |
|---|---|---|---|---|---|---|
| Resin section | Thermoplastic resin | | | | | |
| Length of A section (mm) | 0.6 | 0.8 | 1.0 | 7.8 | 8.0 | 8.2 |
| Length ofB section (mm) | 0.2 | 0.2 | 0.2 | 2.0 | 2.0 | 2.0 |
| Total length of A and B sections (mm) | 0.8 | 1.0 | 1.2 | 9.8 | 10.0 | 10.2 |
| Water resistance evaluation | Fail | Pass | Pass | Pass | Pass | Fail |
| Thermal shock resistance evaluation | Fail | Pass | Pass | Pass | Pass | Fail |
| Reason | Anchoring effect cannot be obtained in consequence of contraction stress | Individual variation in thermal shock resistance starts occurring | | | Individual variation in fillability of B section with resin starts occurring | Fillability of B section is damaged |

The following shows, as the experiment results in which the above-described (2-1) was derived, the results that are obtained when the lengths in the lateral direction of the base end section 121 and the top end section 122 are varied respectively, taking the case in which the thickness of the base end section 121 is 0.5 mm and the thickness of the top end section 122 is 1.1mm, and the angle given by the border between the base end section 121 and the top end section 122 is 90°, as a standard.

It is clear that both Examples 15 and 16, in which the length in the lateral direction of the base end section 121 is the length in the lateral direction of the top end section 122 or more, satisfy both the requirements of the water resistance and shock resistance. Of these examples, Example 15 is determined to show the limit value with respect to the size relation of the length in the lateral direction of the base end section 121 and of the top end section 122, since the individual variation in thermal shock resistance starts occurring.

**[Table 6]**

| | Ex. 15 | Ex. 16 |
|---|---|---|
| Resin section | Thermoplastic resin | |
| Length of A section (mm) | 2.5 | 2.7 |
| Length of B section (mm) | 2.5 | 2.3 |
| Relationship between A and B sections | A=B | A>B |
| Total length of A and B sections (mm) | 5.0 | 5.0 |
| Water resistance evaluation | Pass | Pass |
| Thermal shock resistance evaluation | Pass | Pass |
| Reason | Individual variation in thermal shock resistance starts occurring | |

The following shows, as the experiment results in which the above-described (2-2) was derived, the results that are obtained when the lengths in the lateral direction of the base end section 121 and the top end section 122 are varied respectively, taking the case in which the thickness of the base end section 121 is 0.5 mm and the thickness of the top end section 122 is 1.0 mm, and the angle given by the border between the base end section 121 and the top end section 122 is 90°, as a standard.

As shown in the table below, it is clear that in the cases (Examples 17 and 19), both the requirements of the water resistance and shock resistance are satisfied for all the size relation in the length in the lateral direction of the base end section 121 and of the top end section 122.

**[Table 7]**

| | Ex.17 | Ex.18 | Ex.19 |
|---|---|---|---|
| Resin section | Thermoplastic resin | | |
| Length of A section (mm) | 2.3 | 2.5 | 2.7 |
| Length of B section (mm) | 2.7 | 2.5 | 2.3 |
| Relationship between A and B sections | A<B | A=B | A>B |
| Total length of A and B sections (mm) | 5.0 | 5.0 | 5.0 |
| Water resistance evaluation | Pass | Pass | Pass |
| Thermal shock resistance evaluation | Pass | Pass | Pass |

The following shows, as the experiment results in which the above-described (3) was derived, the results that are obtained when the lengths in the lateral direction of the base end section 121 and the top end section 122 are varied respectively, taking the case where the thickness of the base end section 121 is 0.5 mm and the thickness of the top end section 122 is 0.8 mm, and the angle given by the border between the base end section 121 and the top end section 122 is 90°, as a standard. Note that, for the combinations of the lengths in the lateral direction of the base end section 121 and the top end section 122 that are shown in the table below, the values for the respective elements are selected taking into consideration the above-described conditions (1), (2-1), and (2-2). That is, the definition of the length (an element) is varied taking the standard thickness as a precondition.

Comparative Example 9 and Example 20 show examples in which the total length in the lateral direction of the base end section 121 and the top end section 122 is 1.0 mm, and Comparative Example 10 and Examples 22 and 23 show examples in which the total length in the lateral direction of the base end section 121 and the top end section 122 is 10.0 mm.

Of these examples, cases in which the length in the lateral direction of the top end section 122 is 0.1 mm (Comparative Examples 9 and 11) cannot achieve both the required water resistance and shock resistance. More specifically, since the length in the lateral direction of the top end section 122 is less than 0.2 mm, the fillability with resin is deteriorated. As a result, the required water resistance and shock resistance cannot be exerted.

In contrast thereto, it is clear that the cases in which the length in the lateral direction of the top end section 122 is 0.2 mm or more (Examples 20, 21, 22, and 23) satisfy the requirements of the water resistance and shock resistance. Of these examples, Examples 20 and 22 are determined to show the lower limit of the length in the lateral direction of the top end section 122 since the individual variation in the fillability with resin starts occurring.

**[Table 8]**

| | Comp. Ex. 9 | Ex. 20 | Ex. 21 | Comp. Ex. 10 | Ex. 22 | Ex. 23 |
|---|---|---|---|---|---|---|
| Resin section | Thermoplastic resin | | | | | |
| Length of A section (mm) | 0.9 | 0.8 | 0.7 | 9.9 | 9.8 | 9.7 |
| Length of B section (mm) | 0.1 | 0.2 | 0.3 | 0.1 | 0.2 | 0.3 |
| Total length of A and B sections (mm) | 1.0 | 1.0 | 1.0 | 10.0 | 10.0 | 10.0 |
| Water resistance evaluation | Fail | Pass | Pass | Fail | Pass | Pass |
| Thermal shock resistance evaluation | Fail | Pass | Pass | Fail | Pass | Pass |
| Reason | Fillability of B section is damaged | Individual variation in fillability of B section with resin starts occurring | | Fillability of B section is damaged | Individual variation in fillability of B section with resin starts occurring | |

### <Advantages>

According to the present embodiment, an extension section that has an anchoring section on the outer periphery of an open end of a closing member is provided in a fitting section between a main case (in the above-described examples, the base metal fitting 60) and a closing member (in the above-described examples, the coil case 20). By adopting such an extension section, even when the electronic device is used under the temperature environment in which thermal expansion and contraction occur repeatedly, it is possible to prevent the filling resin from being detached from the closing member, achieving excellent water resistance (sealing property).

Furthermore, by eliminating the adhesive property restriction (restriction that requires a predetermined adhesion strength or greater) between the filling resin and the closing member, it is possible to increase the degree of freedom of the material option of the closing member, that is, to eliminate, for example, a restriction depending on the property such as the bending elastic modulus. By increasing the degree of freedom in selection of the material, it is possible to reduce the material cost for the closing member, to realize the stable procurement thereof, and to adopt a material that has excellent molding properties, improving the production yield of the closing member.

### [Embodiment 2]

Although the foregoing Embodiment 1 has described a structure in which the base end section 121 (A section) and the top end section 122 (B section) are formed adjacent to each other in the axial direction of the central axis 102, Embodiment 2 shows an example of a configuration in which an inclination angle between the base end section 121 (A section) and the top end section 122 (B section) is varied.

FIG. 7 is a cross-sectional view schematically illustrating an extension section 22 that is used for a proximity sensor Embodiment 2. Note that the X axis, the Y axis, and Z axis show the same directions as those in the cross-sectional view of FIG. 6.

As shown in FIG. 7, the base end section 121 is tapered toward the top end section 122 from the open end 21 of the coil case 20 on the rear side. That is, the resin section provided in the gap 130 formed by the engagement structure of the present embodiment is configured so as to further form an intermediate section 123 between the base end section 121 (A section) and the top end section 122 (B section). The intermediate section 123 is configured such that its thickness from the central axis of the base metal fitting 60 (main case) toward the base metal fitting 60 varies along the axial direction, generating, when a force for letting the top end of the base end section 121 (A section) be closer to the top end section 122 (B section) is generated due to contraction of the resin section, a reactive force in the axial direction of the central axis 102 to the extension section 22. In the example shown in FIG. 7, the top end section 122 is convex-shaped with respect to the base end section 121, and the inclination angle of the intermediate section 123 toward the top end section 122 from the base end section 121 is constant. The angle θ given by the surface of the intermediate section 123 and the central axis 102 is defined as "an angle given by a border between the base end section 121 and the top end section 122". In the extension section 22 shown in FIG. 6, it can be assumed that the intermediate section 123 is directed in the direction that is orthogonal to the central axis 102, and this corresponds to the case where the angle θ given by the border of the base end section 121 and the border of the top end section 122 is 90°.

In the anchoring structure including this intermediate section 123, in order to exert the anchoring effect, the angle θ given by the border of the base end section 121 and the border of the top end section 122 is in the range from 90° to 150°.

The reason is that, when the angle θ given by the border of the base end section 121 and the border of the top end section 122 is less than 90°, a metal mold for molding the bent section 26 that is adjacent to the intermediate section 123 is a so-called "undercut" mold, and the coil case 20 cannot be manufactured. Furthermore, when the angle θ given by the border of the base end section 121 and the border of the top end section 122 exceeds 150°, it is not possible to convert expansion and contraction stresses into press stresses that are applied to the bent section 26 from the intermediate section 123. That is, when the angle θ given by the border of the base end section 121 and the border of the top end section 122 is too large, the bent section 26 cannot receive the stress that affects the detachment as a press stress, and does not exert the anchoring effect.

As a result, the inclination angle of the intermediate section 123 (the angle θ given by the border of the base end section 121 and the border of the top end section 122) is preferably 90° to 150° in view of molding of the coil case 20 (preventing a metal mold undercut structure for the bent section 26), and exertion of the anchoring effect.

The following will describe the experiment results in which the above-described condition for the inclination angle of the intermediate section 123 (that is, the inclination angle of the bent section 26) was derived. Note that, in the following experiment results, an example in which a hot melt resin, which is a thermoplastic resin, is used as a resin seal is taken, but the same results are also obtained when a thermosetting resin is used.

Examples 24 to 26, and Comparative Examples 11 and 12 shown in the table below show the results obtained when the angle given by the border between the base end section 121 and the top end section 122 is varied, taking the case in which the thickness of the base end section 121 is 0.9 mm and the thickness of the top end section 122 is 1.0 mm, as a standard.

As shown in the table below, in the case where the angle given by the border between the base end section 121 and the top end section 122 is less than 90° (Comparative Example 11), a metal mold for molding is an undercut mold, and the coil case 20 cannot be manufactured.

Furthermore, in the case where the angle given by the border between the base end section 121 and the top end section 122 is 160° (Comparative Example 12), expansion and contraction stresses cannot be converted into press stresses in the intermediate section, and thus the anchoring effect is not exerted. Accordingly, even if water resistance is ensured before a thermal shock is applied, the thermal shock resistance may be deteriorated by a repeated thermal shock.

Whereas, it is clear that all Examples 24 to 26, in which the angle given by the border between the base end section 121 and the top end section 122 is in the range from 90° to 150°, satisfy the requirements of the water resistance and shock resistance.

**[Table 9]**

| | Comp. Ex. 11 | Ex. 24 | Ex. 25 | Ex. 26 | Comp. Ex. 12 |
|---|---|---|---|---|---|
| Resin section | Thermoplastic resin | | | | |
| Thickness of A section (mm) | 0.9 | 0.9 | 0.9 | 0.9 | 0.9 |
| Thickness of B section (mm) | 0.1 | 1.0 | 1.0 | 1.0 | 1.0 |
| Angle given by border between A and B sections | less than 90° | 90° | 140° | 150° | 160° |
| Water resistance evaluation | - | Pass | Pass | Pass | Pass |
| Thermal shock resistance evaluation | - | Pass | Pass | Pass | Fail |
| Reason | Molding is impossible due to undercut mold | | | Individual variation in thermal shock resistance starts occurring | Anchoring effect is not exerted |

### <Advantages>

According to the present embodiment, in addition to the advantages achieved by the foregoing Embodiment 1, moldability in manufacturing of the extension section 22 (extension section) can be improved since the angle given by the border between the base end section 121 and the top end section 122 can be made larger than 90°, further improving the production yield of the closing member.

### [Embodiment 3]

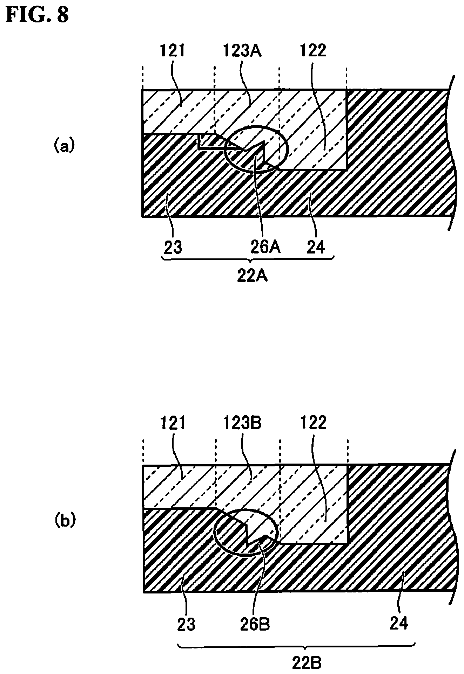

Although the foregoing Embodiment 2 has described an example in which the intermediate section 123 having a predetermined inclination angle between the base end section 121 and the top end section 122 is provided, the intermediate section 123 may have any shape as long as the anchoring effect is exerted. Hereinafter, the shape in which this anchoring effect is exerted will be described with reference to FIGS. 8 to 10.

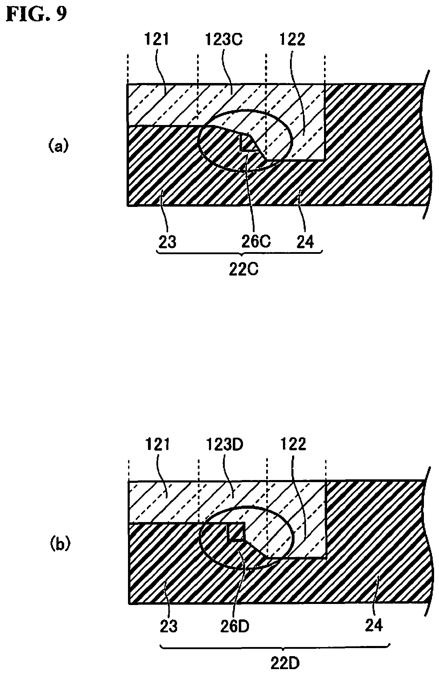

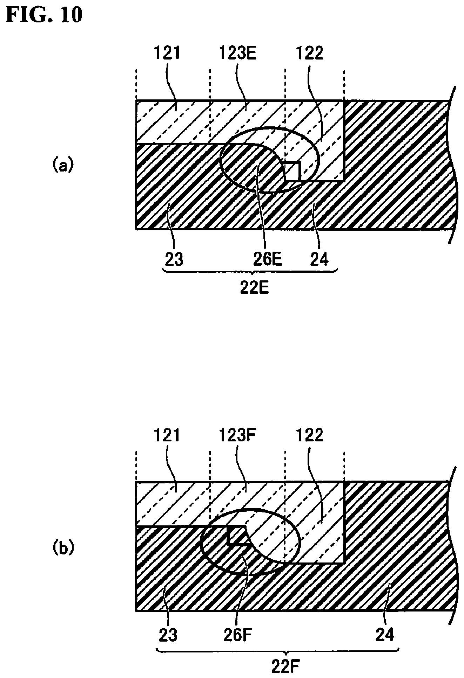

FIG. 8 shows cross-sectional views schematically illustrating extension sections that are used for a proximity sensor of the Embodiment 3. FIG. 9 shows cross-sectional views schematically illustrating other extension sections that are used for the proximity sensor of Embodiment 3. FIG. 10 shows cross-sectional views schematically illustrating yet other extension sections that are used for the proximity sensor of Embodiment 3.

An extension section 22A shown in FIG. 8(a) adopts a bent section 26A that has a projection. For ease of description, FIG. 8(a) schematically shows the resin section that is filled with a resin and is adjacent to the extension section 22A, such that the base end section 121 that is adjacent to the rib-shaped section 23, the intermediate section 123A that is adjacent to the bent section 26A, and the top end section 122 that is adjacent to the anchoring section 24 are clearly distinguished from one another. Note, however, that in the manufacture stage, it is not necessary to clearly distinguish these sections (the same applies to FIGS. 8(a), 9(a), 9(b), 10(a), and 10(b), which will be described later).

In other words, the extension section 22A includes, between the rib-shaped section 23 and the anchoring section 24, the bent section 26A having the convex-shaped projection on the surface thereof. The bent section 26A receives, with the projection on the surface, expansion and contraction stresses generated in the resin section as press stresses.

Similarly, an extension section 22B shown in FIG. 8(b) adopts a bent section 26B that has a recess. That is, the extension section 22B includes, between the rib-shaped section 23 and the anchoring section 24, the bent section 26B having the recess on the surface thereof. The bent section 26B receives, with the recess on the surface, expansion and contraction stresses generated in the resin section as press stresses.

The extension sections shown in FIGS. 8(a) and 8(b) have the projection and the recess on the bent sections 26A and 26B, respectively. This projection and recess may have any structure as long as the metal mold for used in molding is not an undercut mold. However, the tips of the formed projection and the bottom recess have preferably an acute angle.

Accordingly, in each of FIGS. 8(a) and 8(b), when viewed in a cross section that includes the central axis 102 of the base metal fitting 60, which serves as the main case, the border between the intermediate section 123A, 123B and the extension section 22A, 22B is formed on the line that connects an end of a border between the base end section 121 (A section) and the extension section 22A, 22B, to an end of a border between the top end section 122 (B section) and the extension section 22A, 22B, the ends being close to each other, and has the projection whose top has an acute angle or the recess whose bottom has an acute angle.

Next, an extension section 22C shown in FIG. 9(a) adopts a bent section 26C that has multiple angles. The extension section 22C has, between the rib-shaped section 23 and the anchoring section 24, the bent section 26C having multiple angles when viewed in a cross section. Similarly, an extension section 22D shown in FIG. 9(b) adopts a bent section 26D that has multiple angles. The bent sections 26C and 26D receive, with the multiple angles on their surfaces, expansion and contraction stresses generated in the resin section as press stresses.

The extension sections shown in FIGS. 9(a) and 9(b) have the bent sections having multiple angles (polygon), and the multiple angles may be of any structure as long as the metal mold for use in molding is not an undercut mold.

Accordingly, in FIGS. 9(a) and 9(b) each, when viewed in a cross section that includes the central axis 102 of the base metal fitting 60, which serves as the main case, the border between the intermediate section 123C, 123D and the extension section 22C, 22D is formed by a combination of a plurality of lines and, of the plurality of lines, any of pairs of two adjacent lines, namely, a pair of the border between the base end section 121 (A section) and the extension section 22C, 22D, and the adjacent line, and a pair of the border between the top end section 122 (B section) and the extension section 22C, 22D, and the adjacent line is configured to have a larger angle than the right angle.

Next, an extension section 22E shown in FIG. 10(a) adopts a bent section 26E that has a curved surface. The extension section 22E has, between the rib-shaped section 23 and the anchoring section 24, the bent section 26F that is arc-shaped when viewed in the cross section. Similarly, an extension section 22F shown in FIG. 10(b) adopts a bent section 26F that has a curved surface. The bent sections 26F and 26F receive, with their curved surface, expansion and contraction stresses generated in the resin section as press stresses.

In FIGS. 10(a) and 10(b), the bent sections 26E, 26F are formed so as to have a curved surface, and this curved surface may have any structure as long as the metal mold for use in molding is not an undercut mold.

Accordingly, in the extension sections shown in each of FIGS. 10(a) and 10(b), when viewed in a cross section that includes the central axis 102 of the base metal fitting 60, which serves as the main case, the border between the intermediate section 123E, 123F and the extension section 22E, 22F includes an arc.

### <Advantages>

According to the present embodiment, in addition to the advantages achieved by the foregoing Embodiment 1, moldability in manufacturing of the extension section 22 (extension section) can be improved since the shape of the intermediate section 123 and the adjacent bent section between the base end section 121 and the top end section 122 can be designed relatively freely, further improving the production yield of the closing member.

Furthermore, by adopting an appropriately shaped intermediate section 123 and the adjacent bent section, it is possible to further improve the anchoring effect.

### [Embodiment 4]

Although the foregoing Embodiments 1 to 3 have shown configurations in which the base metal fitting 60 and the coil case 20 are cylindrical, any cross-sectional shape may be used for the present invention as long as the base metal fitting 60 and the coil case 20 are tubular. For example, a tubular base metal fitting and a tubular coil case that have any polygonal cross-sectional shape may be used.

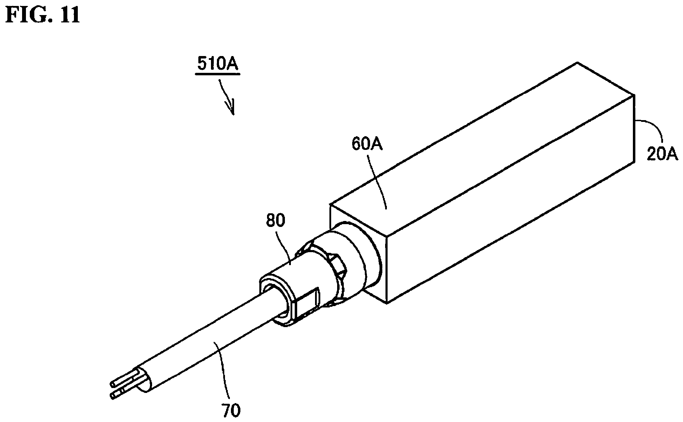

FIG. 11 is a perspective view illustrating a proximity sensor 510A of Embodiment 4. The proximity sensor 510A shown in FIG. 11 has an outer appearance extending in the shape of a quadrangular prism along the central axis. The proximity sensor 510A includes a detecting unit (not shown), a coil case 20A, the printed board (not shown), a base metal fitting 60A, which serves as a housing, the clamp 80A, and the ring cord 70. The engagement structure formed in the proximity sensor 510A of the present embodiment is the same as the engagement structures of the foregoing Embodiments 1 to 3, and detailed descriptions thereof are not repeated.

### [Other Embodiments]

The above-described embodiments have been described, taking the proximity sensor as an example of the electronic device, but the present invention is not limited to the proximity sensor. Typically, the present invention may be applicable to a photoelectric sensor, a fiber sensor, a smart sensor, or the like.

A photoelectric sensor detects presence or absent of an object, a change in a surface state, or the like, using various properties of light emitted from a light emission source. A detecting unit of the photoelectric sensor includes, as the light emission source, a light emitting diode, a semiconductor laser, or the like. A fiber sensor is a sensor in which an optical fiber is incorporated with a photoelectric sensor. A detecting unit of the fiber sensor as well includes, as the light emission source, a light emitting diode, a semiconductor laser, or the like. A smart sensor is a sensor that has, in added to functions of a proximity sensor or a photoelectric sensor, functions to perform analysis and information processing. In the case where a proximity sensor is used as a basic configuration of the smart sensor, a detecting unit corresponds to any one of the detecting units of the above-described embodiments, whereas in the case where a photoelectric sensor is used as a basic configuration of the smart sensor, a light emitting diode, a semiconductor laser, or the like is included as a light emission source.

Although the embodiments and examples according to the present invention have been described, the embodiments and examples disclosed here are, in every respect, exemplary and not restrictive. The technical scope of the present invention is defined by Claims, and the intention is to cover all modifications in the meaning and scope of equivalent to Claims.

### LIST OF REFERENCE NUMERALS

- 20, 20A: Coil case
- 21: Open end
- 22, 22A, 22B, 22C, 22D, 22E, 22F: Extension section
- 23: Rib-shaped section
- 24: Anchoring section
- 26, 26A, 26B, 26C, 26E, 26F: Bent section
- 30: Coil spool
- 36: Electromagnetic coil
- 37: End
- 40: Core
- 46: Coil pin
- 50: Printed board
- 52: Side face
- 60, 60A: Base metal fitting
- 61, 62, 88: Opening
- 63: Inner surface
- 70: Ring cord
- 71: Cable
- 72: Ring member
- 80, 80A: Clamp
- 85: Accommodating section
- 102: Central axis
- 120: Resin section
- 121: Base end section (A section)
- 122: Top end section (B section)
- 123, 123A, 123B, 123C, 123D, 123E, 123F: Intermediate section
- 130: Gap
- 210: Detecting unit
- 310: Cylindrical case
- 510, 510A: Proximity sensor

## Claims

1. An electronic device (510; 510A) comprising:
a main case (60; 60A) that is tubular;
a closing member (20) that closes an opening (61) on one side of the main case (60; 60A);
an electronic component that is arranged inside surrounded by the main case (60; 60A) and the closing member (20); and
a resin section (120) that is formed by a resin injected into the main case (60; 60A);
wherein the closing member (20) has an extension section that forms a space between the extension section and the main case (60; 60A) over the entire circumference of the extension section that is opposite to an inner surface of the main case (60; 60A), the space being filled with the resin,
the resin section (120) includes a first section that is provided in the space, and a second section other than the first section, and
the extension section (22; 22A; 22B; 22C; 22D; 22E; 22F) has, over the entire circumference thereof, an engagement structure for preventing the resin section (120) of the first section from being shifted in the axial direction of the main case (60; 60A),
wherein the resin section (120) of the first section includes a base end section (121) having a first thickness in the direction toward the main case (60; 60A) from the central axis of the main case (60; 60A), and a top end section (122) having a second thickness that is larger than the first thickness in the direction toward the main case (60; 60A) from the central axis of the main case (60; 60A)
**characterized in that**
the resin section (120) of the first section further includes a tapered intermediate section (123; 123A; 123B; 123C; 123D, 123E; 123F) between the base end section (121) and the top end section (122).

2. The electronic device (510; 510A) according to claim 1,
wherein the thickness of the base end section (121) in the direction toward the main case (60; 60A) from the central axis of the main case (60; 60A) is 0.2 to 1.0 mm, and
the thickness of the top end section (122) in the direction toward the main case (60; 60A) from the central axis of the main case (60; 60A) is larger than the thickness of the base end section (121) by 0.1 mm or more.

3. The electronic device (510; 510A) according to claim 1 or 2,
wherein the thickness of the top end section (122) in the direction toward the main case (60; 60A) from the central axis of the main case (60; 60A) is 1.5 mm or less.

4. The electronic device (510; 510A) according to any one of claims 1 to 3,
wherein the total length in the axial direction of the base end section (121) and the top end section (122) is 1.0 mm to 10.0 mm.

5. The electronic device (510; 510A) according to any one of claims 1 to 4,
wherein the intermediate section (123; 123A; 123B; 123C; 123D, 123E; 123F) is configured such that its thickness from the central axis of the main case (60; 60A) toward the main case (60; 60A) varies along the axial direction, generating, when a force for letting an end of the first section be closer to the second section is generated due to contraction of the resin section (120), a reactive force to the extension section (22; 22A; 22B; 22C; 22D; 22E; 22F) in the axial direction.

6. The electronic device (510; 510A) according to any one of claims 1 to 5,
wherein an angle given by a border between the base end section (121) and the top end section (122) is in the range from 90° to 150°.

7. The electronic device (510; 510A) according to any one of claims 1 to 6,
wherein, when viewed in a cross section including the central axis of the main case (60; 60A), a border between the intermediate section (123; 123A; 123B; 123C; 123D, 123E; 123F) and the extension section (22; 22A; 22B; 22C; 22D; 22E; 22F) is formed on a line that connects an end of a border between the base end section (121) and the extension section (22; 22A; 22B; 22C; 22D; 22E; 22F), to an end of a border between the top end section (122) and the extension section (22; 22A; 22B; 22C; 22D; 22E; 22F), the ends being close to each other, and has a projection whose top has an acute angle.

8. The electronic device (510; 510A) according to any one of claims 1 to 7,
wherein, when viewed in a cross section including the central axis of the main case (60; 60A), the border between the intermediate section (123; 123A; 123B; 123C; 123D, 123E; 123F) and the extension section (22; 22A; 22B; 22C; 22D; 22E; 22F) is configured by a combination of a plurality of lines, and a pair of lines selected from:
- two adjacent lines of said plurality of lines,
- a border between the base end section (121) and the extension section (22; 22A; 22B; 22C; 22D; 22E; 22F), and one of said plurality of lines adjacent thereto, and
- a border between the top end section (122) and the extension section (22; 22A; 22B; 22C; 22D; 22E; 22F), and one of said plurality of lines adjacent thereto,
defines an angle that is larger than a right angle.

9. The electronic device (510; 510A) according to any one of claims 1 to 8,
wherein, when viewed in a cross section including the central axis of the main case (60; 60A), the border between the intermediate section (123; 123A; 123B; 123C; 123D, 123E; 123F) and the extension section (22; 22A; 22B; 22C; 22D; 22E; 22F) includes an arc.

10. The electronic device (510; 510A) according to any one of claims 1 to 9, wherein the resin is selected from a thermoplastic resin and a thermosetting resin.

## Patentansprüche

1. Elektronische Vorrichtung (510; 510A), aufweisend:
ein Hauptgehäuse (60; 60A), welches hülsenförmig ist;
ein Verschlusselement (20), welches eine Öffnung (61) an einer Seite des Hauptgehäuses (60; 60A) verschließt;
eine elektronische Komponente, welche innerhalb angeordnet ist und von dem Hauptgehäuse (60; 60A) und dem Verschlusselement (20) umgeben ist; und
einen Harzabschnitt (120), welcher aus einem in das Hauptgehäuse (60; 60A) eingespritzten Harz gebildet ist;
wobei das Verschlusselement (20) einen Erstreckungsabschnitt aufweist, welcher einen Raum zwischen dem Erstreckungsabschnitt und dem Hauptgehäuse (60; 60A) über den gesamten Umfang des Erstreckungsabschnitts, der einer inneren Fläche des Hauptgehäuses (60; 60A) gegenüberliegt, ausbildet, wobei der Raum mit dem Harz gefüllt ist,
der Harzabschnitt (120) einen ersten in dem Raum vorgesehenen Abschnitt und einen zweiten von dem ersten Abschnitt verschiedenen Abschnitt aufweist, und
der Erstreckungsabschnitt (22; 22A; 22B; 22C; 22D; 22E; 22F) über seinen gesamten Umfang zum Verhindern, dass der Harzabschnitt (120) des ersten Abschnitts in der axialen Richtung des Hauptgehäuses (60; 60A) verschoben wird, eine Eingriffsstruktur aufweist,
wobei der Harzabschnitt (120) des ersten Abschnitts einen Basisendabschnitt (121) mit einer ersten Dicke in der Richtung von der Mittelachse des Hauptgehäuses (60; 60A) zu dem Hauptgehäuse (60; 60A) hin und einen oberen Endabschnitt (122) mit einer zweiten Dicke, die größer ist als die erste Dicke in der Richtung von der Mittelachse des Hauptgehäuses (60; 60A) zu dem Hauptgehäuse (60; 60A) hin, aufweist,
**dadurch gekennzeichnet, dass**
der Harzabschnitt (120) des ersten Abschnitts ferner zwischen dem Basisendabschnitt (121) und dem oberen Endabschnitt (122) einen sich verjüngenden Mittelabschnitt (123; 123A; 123B; 123C; 123D; 123E; 123F) aufweist.

2. Elektronische Vorrichtung (510; 510A) nach Anspruch 1,
wobei die Dicke des Basisendabschnitts (121) in der Richtung von der Mittelachse des Hauptgehäuses (60; 60A) zu dem Hauptgehäuse (60; 60A) hin 0,2 bis 1,0 mm ist, und
die Dicke des oberen Endabschnitts (122) in der Richtung von der Mittelachse des Hauptgehäuses (60; 60A) zu dem Hauptgehäuse (60; 60A) hin um 0,1 mm oder mehr größer ist als die Dicke des Basisendabschnitts (121).

3. Elektronische Vorrichtung (510; 510A) nach Anspruch 1 oder 2,
wobei die Dicke des oberen Endabschnitts (122) in der Richtung von der Mittelachse des Hauptgehäuses (60; 60A) zu dem Hauptgehäuse (60; 60A) hin 1,5 mm oder weniger ist.

4. Elektronische Vorrichtung (510; 510A) nach einem der Ansprüche 1 bis 3, wobei in der axialen Richtung die Gesamtlänge des Basisendabschnitts (121) und des oberen Endabschnitts (122) 1,0 mm bis 10,0 mm ist.

5. Elektronische Vorrichtung (510; 510A) nach einem der Ansprüche 1 bis 4,
wobei der Mittelabschnitt (123; 123A; 123B; 123C; 123D; 123E; 123F) so gestaltet ist, dass sich seine Dicke von der Mittelachse des Hauptgehäuses (60; 60A) zu dem Hauptgehäuse (60; 60A) hin entlang der axialen Richtung verändert, wobei an dem Erstreckungsabschnitt (22; 22A; 22B; 22C; 22D; 22E; 22F) eine reaktive Kraft in der axialen Richtung erzeugt wird, wenn aufgrund eines Zusammenziehens des Harzabschnitts (120) eine Kraft erzeugt wird, die einem Ende des ersten Abschnitts erlaubt, näher zu dem zweiten Abschnitt zu sein.

6. Elektronische Vorrichtung (510; 510A) nach einem der Ansprüche 1 bis 5,
wobei ein Winkel, welcher durch einen Übergang zwischen dem Basisendabschnitt (121) und dem oberen Endabschnitt (122) gegeben ist, in dem Bereich von 90° bis 150° liegt.

7. Elektronische Vorrichtung (510; 510A) nach einem der Ansprüche 1 bis 6,
wobei in einer die Mittelachse des Hauptgehäuses (60; 60A) aufweisende Querschnittsansicht eine Grenzfläche zwischen dem Mittelabschnitt (123; 123A; 123B; 123C; 123D; 123E; 123F) und dem Erstreckungsabschnitt (22; 22A; 22B; 22C; 22D; 22E; 22F) auf einer Linie ausgebildet ist, welche ein Ende einer Grenzfläche zwischen dem Basisendabschnitt (121) und dem Erstreckungsabschnitt (22; 22A; 22B; 22C; 22D; 22E; 22F) mit einem Ende einer Grenzfläche zwischen dem oberen Endabschnitt (122) und dem Erstreckungsabschnitt (22; 22A; 22B;
22C; 22D; 22E; 22F) verbindet, wobei die Enden nahe beieinander sind, und einen Vorsprung hat, dessen Oberseite einen spitzen Winkel aufweist.

8. Elektronische Vorrichtung (510; 510A) nach einem der Ansprüche 1 bis 7,
wobei in einer die Mittelachse des Hauptgehäuses (60; 60A) aufweisende Querschnittsansicht die Grenzfläche zwischen dem Mittelabschnitt (123; 123A; 123B; 123C; 123D; 123E; 123F) und dem Erstreckungsabschnitt (22; 22A; 22B; 22C; 22D; 22E; 22F) durch eine Verbindung einer Mehrzahl von Linien gestaltet ist, und ein Paar von Linien, welches ausgewählt ist aus:
- zwei benachbarten Linien von besagter Mehrzahl von Linien,
- einer Grenzfläche zwischen dem Basisendabschnitt (121) und dem Erstreckungsabschnitt (22; 22A; 22B; 22C; 22D; 22E; 22F) und einer von besagter Mehrzahl dazu benachbarter Linien, und
- einer Grenzfläche zwischen dem oberen Endabschnitt (122) und dem Erstreckungsabschnitt (22; 22A; 22B; 22C; 22D; 22E; 22F) und einer von besagter Mehrzahl dazu benachbarter Linien,
einen Winkel definiert, welcher größer ist als ein rechter Winkel.

9. Elektronische Vorrichtung (510; 510A) nach einem der Ansprüche 1 bis 8,
wobei in einer die Mittelachse des Hauptgehäuses (60; 60A) aufweisende Querschnittsansicht die Grenzfläche zwischen dem Mittelabschnitt (123; 123A; 123B; 123C; 123D; 123E; 123F) und dem Erstreckungsabschnitt (22; 22A; 22B; 22C; 22D; 22E; 22F) einen Bogen aufweist.

10. Elektronische Vorrichtung (510; 510A) nach einem der Ansprüche 1 bis 9,
wobei das Harz ausgewählt ist aus einem thermoplastischen Harz und einem duroplastischen Harz.

## Revendications

1. Dispositif électronique (510 ; 510A) comprenant :
un boîtier principal (60 ; 60A) qui est tubulaires ;
un élément de fermeture (20) qui ferme une ouverture (61) sur un côté du boîtier principal (60 ; 60A) ;
un composant électronique qui est disposé à l'intérieur entouré du boîtier principal (60 ; 60A) et de l'élément de fermeture (20) ; et
une section en résine (120) qui est formée par une résine injectée dans le boîtier principal (60 ; 60A) ;
dans lequel l'élément de fermeture (20) comporte une section de prolongement qui forme un espace entre la section de prolongement et le boîtier principal (60 ; 60A) sur toute la circonférence de la section de prolongement qui est en regard d'une surface intérieure du boîtier principal (60 ; 60A), l'espace étant rempli avec la résine,
la section en résine (120) comporte une première section qui se situe dans l'espace, et une seconde section autre que la première section, et
la section de prolongement (22 ; 22A ; 22B ; 22C ; 22D ; 22E ; 22F) comporte, sur toute sa circonférence, une structure de mise en prise destinée à empêcher la section en résine (120) de la première section de se décaler dans la direction axiale du boîtier principal (60 ; 60A),
dans lequel la section en résine (120) de la première section comporte une section d'extrémité de base (121) présentant une première épaisseur en direction du boîtier principal (60 ; 60A) depuis l'axe central du boîtier principal (60 ; 60A), et une section d'extrémité de sommet (122) présentant une seconde épaisseur qui est supérieure à la première épaisseur en direction du boîtier principal (60 ; 60A) depuis l'axe central du boîtier principal (60 ; 60A)
**caractérisé en ce que** :
la section en résine (120) de la première section comporte en outre une section intermédiaire effilée (123 ; 123A ; 123B ; 123C ; 123D ; 123E ; 123F) entre la section d'extrémité de base (121) et la section d'extrémité de sommet (122).

2. Dispositif électronique (510 ; 510A) selon la revendication 1,
dans lequel l'épaisseur de la section d'extrémité de base (121) en direction du boîtier principal (60 ; 60A) depuis l'axe central du boîtier principal (60 ; 60A) est de 0,2 à 1,0 mm, et
l'épaisseur de la section de sommet (122) en direction du boîtier principal (60 ; 60A) depuis l'axe central du boîtier principal (60 ; 60A) est supérieure à l'épaisseur de la section d'extrémité de base (121) d'au moins 0,1 mm.

3. Dispositif électronique (510 ; 510A) selon la revendication 1 ou 2,
dans lequel l'épaisseur de la section d'extrémité de sommet (122) en direction du boîtier principal (60 ; 60A) depuis l'axe central du boîtier principal (60 ; 60A) est inférieure ou égale à 1,5 mm.

4. Dispositif électronique (510 ; 510A) selon l'une quelconque des revendications 1 à 3,
dans lequel la longueur totale dans la direction axiale de la section d'extrémité de base (121) et de la section d'extrémité de sommet (122) est de 1,0 mm à 10,0 mm.

5. Dispositif électronique (510 ; 510A) selon l'une quelconque des revendications 1 à 4,
dans lequel la section intermédiaire (123 ; 123A ; 123B ; 123C ; 123D ; 123E ; 123F) est conçue de manière que son épaisseur depuis l'axe central du boîtier principal (60 ; 60A) en direction du boîtier principal (60 ; 60A) varie le long de la direction axiale, en engendrant, lorsqu'une force destinée à laisser une extrémité de la première section se rapprocher de la seconde section est engendrée du fait de la contraction de la section en résine (120), une force de réaction sur la section de prolongement (22 ; 22A ; 22B ; 22C ; 22D ; 22E ; 22F) dans la direction axiale.

6. Dispositif électronique (510 ; 510A) selon l'une quelconque des revendications 1 à 5,
dans lequel un angle formé par une frontière entre la section d'extrémité de base (121) et la section d'extrémité de sommet (122) se situe dans la plage de 90° à 150°.

7. Dispositif électronique (510 ; 510A) selon l'une quelconque des revendications 1 à 6,
dans lequel, vue sur une coupe transversale incluant l'axe central du boîtier principal (60 ; 60A), une frontière entre la section intermédiaire (123 ; 123A ; 123B ; 123C ; 123D ; 123E ; 123F) et la section de prolongement (22 ; 22A ; 22B ; 22C ; 22D ; 22E ; 22F) est formée sur une ligne qui relie une extrémité de frontière entre la section d'extrémité de base (121) et la section de prolongement (22 ; 22A ; 22B ; 22C ; 22D ; 22E ; 22F), à une extrémité de frontière entre la section d'extrémité de sommet (122) et la section de prolongement (22 ; 22A ; 22B ; 22C ; 22D ; 22E ; 22F), les extrémités étant plus proches l'une de l'autre, et présente une saillie dont le sommet présente un angle aigu.

8. Dispositif électronique (510 ; 510A) selon l'une quelconque des revendications 1 à 7,
dans lequel, lorsque vue sur une coupe transversale incluant l'axe central du boîtier principal (60 ; 60A), la frontière entre la section intermédiaire (123 ; 123A ; 123B ; 123C ; 123D ; 123E ; 123F) et la section de prolongement (22 ; 22A ; 22B ; 22C ; 22D ; 22E ; 22F) est configurée par une combinaison d'une pluralité de lignes, et une paire de lignes choisies parmi :
- deux lignes adjacentes de ladite pluralité de lignes,
- une frontière entre la section d'extrémité de base (121) et la section de prolongement (22 ; 22A ; 22B ; 22C ; 22D ; 22E ; 22F), et une ligne de ladite pluralité de lignes qui lui est adjacente, et
- une frontière entre la section d'extrémité de sommet (122) et la section de prolongement (22 ; 22A ; 22B ; 22C ; 22D ; 22E ; 22F), et une ligne de ladite pluralité de lignes qui lui est adjacente,
définit un angle qui est supérieur à un angle droit.

9. Dispositif électronique (510 ; 510A) selon l'une quelconque des revendications 1 à 8,
dans lequel, lorsque vue sur une coupe transversale incluant l'axe central du boîtier principal (60 ; 60A), la frontière entre la section intermédiaire (123 ; 123A ; 123B ; 123C ; 123D ; 123E ; 123F) et la section de prolongement (22 ; 22A ; 22B ; 22C ; 22D ; 22E ; 22F) inclut un arc.

10. Dispositif électronique (510 ; 510A) selon l'une quelconque des revendications 1 à 9,
dans lequel la résine est choisie parmi une résine thermoplastique et une résine thermodurcissable.
